Europäisches Patentamt

(19) European Patent Office

Office européen des brevets

(11) Veröffentlichungsnummer: **0 030 274**
**B1**

(12) **EUROPÄISCHE PATENTSCHRIFT**

(45) Veröffentlichungstag der Patentschrift:
14.03.84

(51) Int. Cl.³: **H 01 L 29/74,** H 01 L 29/743,
H 01 L 29/52, H 01 L 29/08

(21) Anmeldenummer: 80106774.5

(22) Anmeldetag: 04.11.80

(54) Thyristor mit steuerbaren Emitter-Kurzschlüssen und Verfahren zu seinem Betrieb.

(30) Priorität: 09.11.79 DE 2945366

(43) Veröffentlichungstag der Anmeldung:
17.06.81 Patentblatt 81/24

(45) Bekanntmachung des Hinweises auf die Patenterteilung:
14.03.84 Patentblatt 84/11

(84) Benannte Vertragsstaaten:
CH FR GB IT LI SE

(56) Entgegenhaltungen:
DE - A - 2 625 917
FR - A - 1 362 724

(73) Patentinhaber: SIEMENS AKTIENGESELLSCHAFT,
Berlin und München Wittelsbacherplatz 2,
D-8000 München 2 (DE)

(72) Erfinder: Patalong, Hubert, Dr.,
Kurt-Floericke-Strasse 18, D-8000 München 60 (DE)

Thyristor mit steuerbaren Emitter-Kurzschlüssen und Verfahren zu seinem Betrieb

Die Erfindung bezieht sich auf einen Thyristor mit steuerbaren Emitter-Kurzschlüssen nach dem Oberbegriff des Patentanspruchs 1 und auf Verfahren zu seinem Betrieb. Ein derartiger Thyristor ist aus der DE-A-2 625 917 bekannt.

Ferner sind aus der US-PS 3 243 669 ähnliche Thyristoren bekannt. Beim Anlegen einer Steuerspannung an das Gate einer MIS-Struktur dieser Thyristoren wird hierbei ein Kurzschlußpfad wirksam geschaltet, der den PN-Übergang zwischen der mit der Kathode (Anode) verbundenen Emitterschicht und der angrenzenden Basisschicht überbrückt. Das hat eine Umschaltung des Thyristors aus dem stromführenden Zustand in den blockierten Zustand zur Folge, in dem zwischen Kathode und Anode trotz einer in Durchlaßrichtung anliegenden Spannung praktisch kein Strom fließt. Die Umschaltung aus dem blockierten Zustand in den stromführenden Zustand erfolgt durch das Anlegen einer weiteren Steuerspannung an das Gate einer weiteren MIS-Struktur, die den PN-Übergang zwischen den beiden Basisschichten niederohmig überbrückt.

Andererseits ist beispielsweise aus der DE-AS 2 438 894 ein Thyristor mit einem Kurzschlußemitter bekannt, bei dem eine außenliegende Emitterzone von mehreren, als Teile der angrenzenden Basisschicht aufzufassenden Kurzschlußzonen durchdrungen wird, die sich bis zur Grenzfläche des Thyristorkörpers erstrecken und in dieser mit der Kathode verbunden sind. Nachteilig ist hierbei, daß viele Kurzschlußzonen vorgesehen werden müssen, um eine gute Stabilität des Thyristors zu erreichen, d. h., eine große Sicherheit gegen unbeabsichtigte Zündvorgänge beim Auftreten von in Durchlaßrichtung gepolten Spannungen an der Anoden-Kathoden-Strecke, die teilweise sehr schnell ansteigen (hohe dU/dt-Belastung). Durch eine große Anzahl von Kurzschlußzonen wird jedoch das Zündverhalten stark beeinträchtigt. Der erforderliche Zündstrom wird groß. Die gezündete Fläche des Thyristors breitet sich in lateraler Richtung nur langsam über den gesamten Querschnitt aus. Als Folge hiervon entstehen erhebliche Einschaltverluste.

Der Erfindung liegt die Aufgabe zugrunde, einen Thyristor, der zur Erzielung einer guten Stabilität mit Emitter-Kurzschlüssen versehen ist, hinsichtlich seines Einschaltverhaltens zu verbessern. Das wird erfindungsgemäß durch die im Patentanspruch 1 gekennzeichneten Merkmale erreicht.

Der mit der Erfindung erzielbare Vorteil liegt insbesondere darin, daß im Vergleich zu den Thyristoren mit Kurzschlußzonen sowohl eine bessere Stabilität als auch ein besseres Zündverhalten im Hinblick auf eine schnelle, kontrollierte Zündung über den gesamten Thyristorquerschnitt erreicht werden, obwohl das bei Thyristoren mit Kurzschlußzonen einander widersprechende Forderungen sind. Andererseits ist die Steuerung des Zündvorgangs wesentlich einfacher als bei dem bekannten Thyristor mit den MIS-Kurzschlußpfaden, da eine Steuerung des PN-Übergangs zwischen den beiden Basisschichten entfällt.

Die Patentansprüche 2 bis 4 sind auf bevorzugte Weiterbildungen und Ausgestaltungen der Erfindung gerichtet, während die Ansprüche 5 und 6 bevorzugte Verfahren zum Betrieb eines Thyristors nach der Erfindung betreffen.

Die Erfindung wird nachfolgend an Hand der Zeichnung näher erläutert. Dabei zeigt

Fig. 1 den Querschnitt eines ersten Ausführungsbeispiels der Erfindung,

Fig. 2 eine Draufsicht der Anordnung nach Fig. 1 und

Fig. 3 den Querschnitt eines zweiten Ausführungsbeispiels.

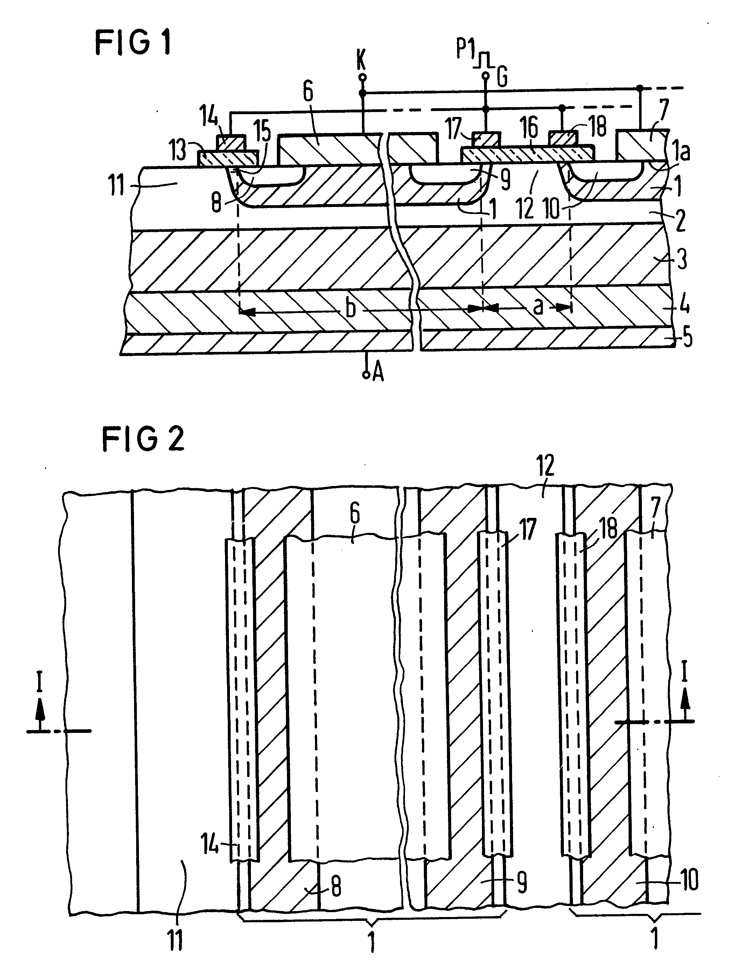

Der in Fig. 1 und Fig. 2 dargestellte Thyristor weist einen Halbleiterkörper mit Halbleiterschichten 1 bis 4 abwechselnder Leitfähigkeitstypen auf, die beispielsweise aus dotiertem Silizium bestehen. Dabei werden die außenliegende N-leitende Schicht 1 als N-Emitterschicht und die außenliegende P-leitende 4 als P-Emitterschicht bezeichnet. Die P-leitende Schicht 2 und die N-leitende Schicht 3 stellen die sogenannten Basisschichten dar. Die P-Emitterschicht 4 ist mit einer Anode 5 versehen, die einen Anodenanschluß A besitzt, während die N-Emitterschicht 1 in mehrere streifenförmige Emitterzonen aufgeteilt ist, von denen nur zwei dargestellt sind. Diese sind in Fig. 2 als vertikal verlaufende, parallele Streifen erkennbar. Jede der Emitterzonen 1 ist mit einem Teil 6, 7 einer Kathode versehen, wobei die einzelnen Teile der Kathode untereinander leitend verbunden und an einen gemeinsamen Kathodenanschluß K geführt sind.

In der Fig. 1, die einen Querschnitt längs der Linie I-I von Fig. 2 zeigt, sind P-leitende erste Halbleitergebiete 8 bis 10 erkennbar, die in die N-Emitterzone 1 so eingefügt sind, daß sie sich bis zur Grenzfläche 1a des Halbleiterkörpers erstrecken. In Fig. 2 sind die Oberflächen dieser Halbleitergebiete der besseren Übersichtlichkeit wegen schraffiert dargestellt. Die Gebiete 8 bis 10 werden jeweils randseitig von den Teilen 6, 7 der Kathode kontaktiert. Mit 11 und 12 sind die die zweiten Halbleitergebiete bildenden Zonen der Basisschicht 2 bezeichnet, die bis an die Grenzfläche 1a reichen und die streifenförmigen Emitterzonen 1 voneinander trennen. Das Gebiet 8 bildet ein erstes P-Gebiet, die Zone 11 ein zweites P-Gebiet und der dazwischenliegende Teil der linken N-Emitterzone 1 eine N-Zwischenschicht. Auf der Grenzfläche 1a ist ein dünne, elektrisch isolierende Schicht 13, z. B. aus $SiO_2$, vorgesehen, auf der ein Gate 14 so angeordnet ist, daß es die N-Zwischenschicht überdeckt. Die Teile 8, 1, 11, 13 und 14 bilden eine MIS-Struktur. Gehört sie dem Verarmungstyp an, so befindet sich ohne Einwirkung einer Spannung auf das Gate 14 ein P-leitender Inversionskanal 15 an der Grenzfläche 1a zwischen den Gebieten 8 und 11, der diese leitend miteinander verbindet. Legt man eine positive Steuerspannung an einen Steuerspannungsanschluß G des Gate 14, so wird der Inversionskanal beseitigt. Ist die MIS-Struktur vom Anreicherungstyp, so besteht bei spannungslosem Gate kein Inversionskanal 15. Dieser wird erst durch das Anlegen einer negativen Steuerspannung an G durch Inversion der Emitterzone 1 unterhalb des Gate 14 aufgebaut.

Der Inversionskanal 15 stellt also einen steuerbaren Emitterkurzschluß dar, der die Basisschicht 2 mit dem Gebiet 8 und damit mit der Kathode in Abhängigkeit von einer dem Anschluß G zugeführten Steuerspannung niederohmig verbindet oder nicht.

Durch die Anordnung einer elektrisch isolierenden Schicht 16, z. B. aus $SiO_2$, auf der zwei ebenfalls mit G verbundene Gates 17 und 18 vorgesehen sind, ergeben sich in analoger Weise MIS-Strukturen 9, 1, 12, 16 und 17 am rechten Rand der linken N-Emitterzone 1 und 10, 1, 12, 16 und 18 am linken Rand der rechten N-Emitterzone. Damit sind in Fig. 1 insgesamt drei randseitig zu den Emitterzonen angeordnete, steuerbare Emitterkurzschlüsse vorgesehen. In dem nicht mehr dargestellten Teil des Thyristors, der sich in Fig. 1 nach rechts hin erstreckt, sind aber noch weitere N-Emitterzonen vorhanden, die jeweils mit einem oder zwei randseitigen Emitterkurzschlüssen versehen sind. Alle diese Emitterkurzschlüsse liegen zweckmäßigerweise an dem Steuerspannungsanschluß G, während die Teile der Kathode, z. B. 6 und 7, die die N-Emitterzonen jeweils kontaktieren, untereinander leitend verbunden und an den Kathodenanschluß K geführt sind.

Bei MIS-Strukturen des Verarmungstyps sind die Emitterkurzschlüsse bei spannungslosem Anschluß G jeweils wirksam. Dabei befindet sich der Thyristor im blockierten Zustand, in dem trotz einer in Durchlaßrichtung gepolten Spannung an den Anschlüssen A und K zwischen den letzteren praktisch kein Strom fließt. Die thermisch generierten Defektelektronen werden aus der Basisschicht 2 zur Kathode abgeleitet, so daß aus den N-Emitterzonen 1 keine Ladungsträger in die Basisschicht 2 injiziert werden. Für ein stabiles Verhalten des Thyristors ist es zweckmäßig, daß die steuerbaren Emitterkurzschlüsse etwa 0,01% bis 3% der Thyristorfläche einnehmen, was unter der Voraussetzung einer gleichmäßigen Verteilung der Emitterzonen 1 über die Grenzfläche 1a in der Weise erläutert werden kann, daß die in Fig. 1 eingezeichneten Strecken a und b zueinander etwa im Verhältnis von 1 : 10 000 bis 3 : 100 stehen. Für die Länge eines Inversionskanals 15 kommen beispielsweise Werte von 2 bis 3 μm in Betracht. Führt man dem Anschluß G einen positiven Spannungsimpuls P1 zu, so werden die Emitterkurzschlüsse lediglich für die Dauer von P1 unwirksam geschaltet, und die Zündung des Thyristors erfolgt. Danach fließt ein Laststrom eines an A und K angeschlossenen Lastkreises über den niederohmig geschalteten Thyristor. Die Abschaltung desselben wird durch eine Abschaltung der zwischen A und K in Durchlaßrichtung anliegenden Spannung erreicht oder, falls es sich bei ihm um eine Wechselspannung handelt, durch den nächstfolgenden Nulldurchgang.

In einigen Anwendungsfällen kann es erwünscht sein, MIS-Strukturen des Anreicherungstyps zu verwenden. Hierbei liegt dann G ständig an einer negativen Vorspannung, die zum Zwecke der Zündung durch den positiven Impuls P1 aufgehoben oder überkompensiert wird, so daß während des Zündvorgangs an G keine Spannung oder im Falle der Überkompensation ein positiver Impuls anliegt.

Anstelle der N-Emitterschicht 1 kann auch die P-Emitterschicht 4 in einzelne Emitterzonen aufgeteilt sein, die mit einzelnen, untereinander verbundenen Teilen der Anode belegt sind. Hierbei sind steuerbare P-Emitterkurzschlüsse vorgesehen. Die Fig. 1 und 2 können zur Darstellung dieser Variante herangezogen werden, wenn die Bezeichnungen der Anschlüsse A und K miteinander vertauscht werden und die Halbleiterteile 1 bis 4 und 8 bis 10 jeweils die entgegengesetzten Leitfähigkeiten zu den bisher beschriebenen aufweisen. Der Spannungsimpuls P1 hat dann ein negatives Vorzeichen. Handelt es sich um MIS-Strukturen des Anreicherungstyps, so ist G eine positive Vorspannung zuzuführen, die durch einen negativen Impuls P1 kurzzeitig kompensiert wird.

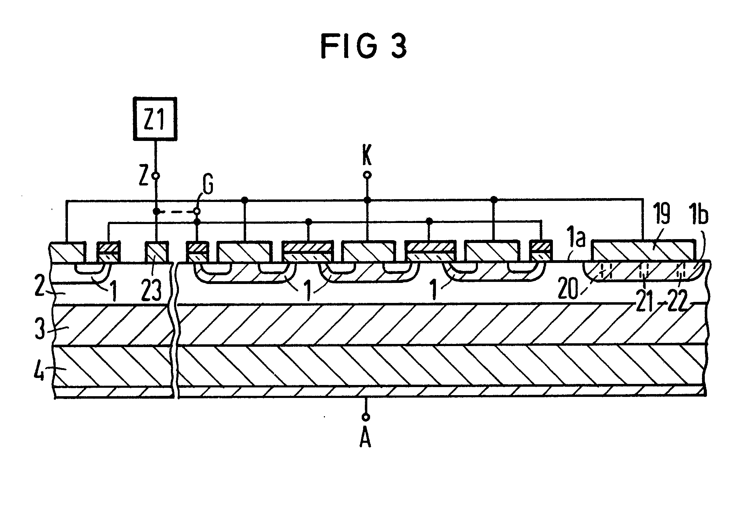

Fig. 3 zeigt ein zweites Ausführungsbeispiel der Erfindung, bei dem neben den bereits beschriebenen N-Emitterzonen 1 noch eine weitere N-Emitterzone 1b vorgesehen ist, die von einem weiteren Teil 19 der Kathode kontaktiert wird. Sie wird von Zonen 20 bis 22 der Basisschicht 2 durchdrungen, die sich bis zur Grenzfläche 1a erstrecken und in dieser ebenfalls von dem Teil 19 kontaktiert werden. Die Zonen 20 bis 22 bilden somit feste N-Emitterkurzschlüsse. Bei dem Thyristor nach Fig. 3, der wegen der Emitterzone 1b größere Lastströme beherrscht als der nach Fig. 1, verhindern die festen Emitter-Kurzschlüsse 20 bis 22 ein Absinken der Stabilität.

Wie aus Fig. 3 ersichtlich ist, kann eine Zündelektrode 23 auf einem Teil der Basisschicht 2 vorgesehen sein, die einen Anschluß Z für einen Zündstromkreis Z1 aufweist. Nach einer Weiterbildung der Erfindung kann der Steuerspannungsanschluß G auch mit dem Anschluß Z verbunden sein, wie gestrichelt dargestellt ist. In diesem Fall wird ein an Z abgreifbarer Zündspannungsimpuls als Impuls P1 verwendet.

Die Emitterzonen 1 können, wie in Fig. 2 angedeutet ist, über die ganze Thyristorfläche geradlinig verlaufen, wobei eine gegebenenfalls vorhandene Zündelektrode 23 zweckmäßigerweise ebenfalls streifenförmig ausgebildet ist. Andererseits können die Emitterzonen 1 auch als konzentrische Ringe ausgebildet sein, wobei eine Zündelektrode 23 mit Vorteil im Zentrum solcher Emitterzonen angeordnet wird. Weitere N-Emitterzonen 1b würden dann ebenfalls ringförmig angeordnet sein.

**Patentansprüche**

1. Thyristor mit einem Halbleiterkörper, der eine außenliegende, mit einer Kathode (6) versehene N-Emitterschicht (1), eine außenliegende, mit einer Anode (5) versehene P-Emitterschicht (4) und zwei an diese jeweils angrenzende Basisschichten (2, 3) enthält, mit an einer Grenzfläche des Halbleiterkörpers angeordneten, als MIS-Strukturen ausgebildeten, steuerbaren Emitter-Kurzschlüssen (8, 1, 11, 13, 14; 9, 1, 12, 16, 17), bestehend aus jeweils einem mit der Kathode bzw. Anode verbundenen ersten Halbleitergebiet (8, 9) eines ersten Leitfähigkeitstyps, einem mit der der Kathode bzw. Anode zugewandten Basisschicht verbundenen zweiten Halbleitergebiet (11, 12) des ersten Leitfähigkeitstyps und einer zwischen diesen Gebieten liegenden Zwischenschicht eines zweiten Leitfähigkeitstyps, die von einem gegenüber dem Halbleiterkörper elektrisch isolierten Gate überdeckt ist, mit einer N-Emitterschicht bzw. P-Emitterschicht, die in eine Mehrzahl von Emitterzonen (1) aufgeteilt ist, die jeweils mit untereinander leitend verbundenen Teilen (6, 7) der Kathode bzw. Anode versehen sind, mit einer Mehrzahl von streifenförmigen MIS-Strukturen (8, 1, 11, 13, 14; 9, 1, 12, 16, 17), die jeweils randseitig zu den Emitterzonen (1) angeordnet sind, und mit Gates (14, 17, 18) der MIS-Strukturen, die einen gemeinsamen Steuerspannungsanschluß (G) aufweisen, dadurch gekennzeichnet, daß die ersten Halbleitergebiete (8, 9) der MIS-Strukturen jeweils derart in die streifenförmigen Emitterzonen (1) eingefügt sind, daß sie sich bis zur Grenzfläche (1a) des Halbleiterkörpers erstrecken, in der sie mit den Teilen (6, 7) der Kathode bzw. Anode leitend verbunden sind, daß die zweiten Halbleitergebiete der MIS-Strukturen jeweils aus Zonen (11, 12) der an die N-Emitterschicht bzw. P-Emitterschicht (1) angrenzenden Basisschicht (2) bestehen, die sich bis an die Grenzfläche (1a) erstrecken, und daß die Zwischenschichten jeweils aus den Teilen der Emitterzonen (1) bestehen, die sich zwischen den einander gegenüberliegenden Grenzflächen der die zweiten Halbleitergebiete bildenden Zonen (11, 12) der Basisschicht (2) und der ersten Halbleitergebiete (8, 9) befinden.

2. Thyristor nach Anspruch 1, dadurch gekennzeichnet, daß mindestens eine weitere N-Emitterzone bzw. P-Emitterzone (1b) vorgesehen ist, die mit mindestens einem weiteren Teil der Kathode bzw. Anode (9) versehen ist, daß die weitere N-Emitterzone bzw. P-Emitterzone (1b) von mindestens einer weiteren Zone (20) der Basisschicht (2) durchdrungen ist, und daß sich diese Zone (20) der Basisschicht bis zur Grenzfläche (1a) des Halbleiterkörpers erstreckt und in dieser mit dem weiteren Teil der Kathode bzw. Anode (19) verbunden ist.

3. Thyristor nach einem der vorhergehenden Ansprüche, dadurch gekennzeichnet, daß eine Basisschicht (2) oder eine Zone derselben mit einer Zündelektrode (23) versehen ist, die einen Anschluß (Z) für einen Zündstromkreis (Z1) aufweist.

4. Thyristor nach Anspruch 3, dadurch gekennzeichnet, daß der Anschluß (Z) für den Zündstromkreis (Z1) mit dem Steuerspannungsanschluß (G) der MIS-Strukturen verbunden ist.

5. Verfahren zum Betrieb eines Thyristors mit einem Halbleiterkörper, der eine außenliegende, mit einer Kathode (6) versehene N-Emitterschicht (1), eine außenliegende, mit einer Anode (5) versehene P-Emitterschicht (4) und zwei an diese jeweils angrenzende Basisschichten (2, 3) enthält, mit an einer Grenzfläche des Halbleiterkörpers angeordneten, als MIS-Strukturen ausgebildeten, steuerbaren Emitter-Kurzschlüssen (8, 1, 11, 13, 14; 9, 1, 12, 16, 17), bestehend aus jeweils einem mit der Kathode bzw. Anode verbundenen ersten Halbleitergebiet (8, 9) eines ersten Leitfähigkeitstyps, einem mit der der Kathode bzw. Anode zugewandten Basisschicht verbundenen zweiten Halbleitergebiet (11, 12) des ersten Leitfähigkeitstyps und einer zwischen diesen Gebieten liegenden Zwischenschicht eines zweiten Leitfähigkeitstyps, die von einem gegenüber dem Halbleiterkörper elektrisch isolierten Gate überdeckt ist, mit einer N-Emitterschicht bzw. P-Emitterschicht, die in eine Mehrzahl von Emitterzonen (1) aufgeteilt ist, die jeweils mit untereinander leitend verbundenen Teilen (6, 7) der Kathode bzw. Anode versehen sind, mit einer Mehrzahl von streifenförmigen MIS-Strukturen (8, 1, 11, 13, 14; 9, 1, 12, 16, 17), die jeweils randseitig zu den Emitterzonen (1) angeordnet sind, und mit Gates (14, 17, 18) der MIS-Strukturen, die einen gemeinsamen Steuerspannungsanschluß (G) aufweisen, dadurch gekennzeichnet, daß dem Steuerspannungsanschluß (G) zur Zündung des Thyristors ein die Emitter-Kurzschlüsse unwirksam schaltender Spannungsimpuls (P1) zugeführt wird.

6. Verfahren nach Anspruch 5, dadurch gekennzeichnet, daß dem Steuerspannungsanschluß (G) der den N- bzw. P-Emitterzonen zugeordneten MIS-Strukturen des Verarmungstyps ein die Umschaltung des Thyristors aus dem blockierten Zustand in den stromführenden Zustand veranlassender, positiver bzw. negativer Spannungsimpuls (P1) zugeführt wird.

7. Verfahren nach Anspruch 5, dadurch gekennzeichnet, daß ein an dem Anschluß (Z) für den Zündstromkreis (Z1) abgreifbarer Zündspannungsimpuls dem Steuerspannungsanschluß (G) der den N- bzw. P-Emitterzonen zugeordneten MIS-Strukturen des Verarmungstyps als ein die Umschaltung des Thyristors aus dem blockierten Zustand in den stromführenden Zustand veranlassender, positiver bzw. negativer Spannungsimpuls zugeführt wird.

## Claims

1. A thyristor having a semiconductor body containing an exterior N-emitter layer (1) provided with a cathode (6), an exterior P-emitter layer (4) provided with an anode (5), two base layers (2, 3) which respectively adjoin these layers (1, 4), and controllable emitter short-circuits (8, 1, 11, 13, 14; 9, 1, 12, 16, 17) which are constructed as MIS structures and are arranged on a boundary surface of the semiconductor body and which respectively consist of a first semiconductor region (8, 9) of a first conductivity type which is connected to the cathode or anode, as the case may be, a second semiconductor region (11, 12) of the first conductivity type which is connected to the base layer facing the cathode or anode, as the case may be, and an intermediate layer of a second conductivity type which is arranged between said zones and which is covered by a gate which is electrically insulated from the semiconductor body; and having an N-emitter layer or P-emitter layer, as the case may be, which is divided into a plurality of emitter zones (1) which are respectively provided with parts (6, 7) of the cathode or anode, as the case may be, which are conductively connected to one another; having a plurality of strip-shaped MIS structures (8, 1, 11, 13, 14; 9, 1, 12, 16, 17) which are respectively arranged at the edge of the emitter zones (1); and having gates (14, 17, 18) of the MIS structures which possess a common control voltage terminal (G), characterised in that the first semiconductor regions (8, 9) of the MIS structures are respectively inserted into the strip-shaped emitter zones (1) in such a way that they extend to the boundary surface (1a) of the semiconductor body, said regions being conductively connected to the parts (6, 7) of the cathode or anode, as the case may be; that the second semiconductor regions of the MIS structures respectively consist of zones (11, 12) of the base layer (2), which adjoins the N-emitter or P-emitter layer, as the case may be, said zones extending to the boundary surface (1a); and that the intermediate layers respectively consist of the parts of the emitter zones (1) which are present between the opposite boundary surfaces of the zones (11, 12) of the base layer (2) and of the first semiconductor regions (8, 9).

2. A thyristor according to Claim 1, characterised in that there is provided at least one further N-emitter zone or P-emitter zone (1b) which is provided with at least one further part of the cathode or anode (9), as the case may be; that the further N-emitter zone or P-emitter zone (1b), as the case may be, is penetrated by at least one further zone (20) of the base layer (2); and that the zone (20) of the base layer extends to the boundary surface (1a) of the semiconductor body and is connected to the further part of the cathode or anode (19), as the case may be, in said boundary surface.

3. A thyristor according to one of the preceding Claims, characterised in that one base layer (2), or a zone thereof, is provided with an ignition electrode (23) which has a terminal (Z) for an ignition circuit (Z1).

4. A thyristor according to Claim 3, characterised in that the terminal (Z) for the ignition circuit (Z1) is connected to the control voltage terminal (G) of the MIS structures.

5. A method of operating a thyristor having a semiconductor body containing an exterior N-emitter layer (1) provided with a cathode (6), and an exterior P-emitter layer (4) provided with an anode (5), two base layers (2, 3) which respectively adjoin these layers (1, 4), and controllable emitter short-circuits (8, 1, 11, 13, 14; 9, 1, 12, 16, 17) which are constructed as MIS structures and are arranged on a boundary surface of the semiconductor body and which respectively consist of a first semiconductor region (8, 9) of a first conductivity type which is connected to the cathode or anode, as the case may be, a second semiconductor region (11, 12) of the first conductivity type which is connected to the base layer facing the cathode or anode, as the case may be, and an intermediate layer of a second conductivity type which is arranged between said regions and covered by a gate which is electrically insulated from the semiconductor body; and having an N-emitter layer or P-emitter layer, as the case may be, which is divided into a plurality of emitter zones (1) which are respectively provided with parts (6, 7) of the cathode or anode, as the case may be, which are conductively connected to one another; having a plurality of strip-shaped MIS structures (8, 1, 11, 13, 14; 9, 1, 12, 16, 17) which are respectively arranged at the edge of the emitter zones (1); and having gates (14, 17, 18) of the MIS structures which possess a common control voltage terminal (G), characterised in that, in order to ignite the thyristor, the control voltage terminal (G) is supplied with a voltage pulse (P1) which switches the emitter short-circuits so as to be ineffective.

6. A method according to Claim 5, characterised in that the control voltage terminal (G) of the MIS structures of the depletion type allotted to the N- or P-emitter zones, as the case may be, is fed with a positive or negative voltage pulse (P1), as the case may be, which causes the thyristor to be switched over from the blocked state to the current-carrying state.

7. A method according to Claim 5, characterised in that an ignition voltage pulse, which can be tapped at the terminal (Z) for the ignition circuit (Z1) is fed to the control voltage terminal (G) of the MIS structures of the depletion type which are allotted to the N- or P-emitter zones, as the case may be, as a positive or negative voltage pulse, as the case may be, which causes the thyristor to be switched over from the blocked state to the current-carrying state.

## Revendications

1. Thyristor à corps semiconducteur, qui comporte une couche extérieure d'émetteur du type N (1), munie d'une cathode (6), une couche extérieure d'émetteur du type P (4), munie d'une anode (5), et deux couches de base (2, 3) contiguës à ces couches d'émetteur, et comportant des courts-circuits d'émetteur (8, 1, 11, 13, 14; 9, 1, 12, 16, 17) pouvant être commandés, réalisés sous la forme de structures MIS et disposés au niveau d'une surface limite du corps semiconducteur et constitués respectivement par une première région semiconductrice (8, 9) d'un premier type de conductivité, reliée à l'anode ou à la cathode, une seconde région semiconductrice (11, 12) du premier type de conductiviti, reliée à la couche de base tournée vers la cathode ou vers l'anode, et par une couche intercalaire possédant un second type de conductivité, qui est disposée entre lesdites couches semiconductrices et qui est recouverte par une grille isolée électriquement par rapport au corps semiconducteur, et comportant une couche d'émetteur du type N ou une couche d'émetteur du type P, qui est subdivisée en plusieurs zones d'émetteur (1), qui sont munies respectivement de parties (6, 7), reliées de façon conductrice entre elles, de la cathode ou de l'anode, et plusieurs structures MIS en forme de bandes (8, 1, 11, 13, 14; 9, 1, 12, 16, 17) qui sont disposées respectivement sur le bord des zones d'émetteur (1) et des grilles (14, 17, 18) des structures MIS, qui possèdent une borne commune (G) d'application d'une tension de commande, caractérisé par le fait que les premières régions semiconductrices (8, 9) des structures MIS sont insérées respectivement dans les zones d'émetteur en forme de bandes (1) de telle sorte qu'elles s'étendent jusqu'à la surface limite (1a) du corps semiconducteur, dans laquelle elles sont reliées de façon conductrice à des parties (6, 7) de la cathode ou de l'anode, que les secondes régions semiconductrices des structures MIS sont constituées respectivement par des zones (11, 12) de la couche de base (2) contiguë à la couche d'émetteur du type N ou à la couche d'émetteur du type P (1), qui s'étendent jusqu'au niveau de la surface limite (1a) et que les couches intercalaires sont constituées respectivement par des parties des zones d'émetteur (1) qui sont situées entre les surfaces limites, situées en vis-à-vis, des zones (11, 12) constituant les secondes régions semiconductrices de la couche de base (2) et les premières régions semiconductrices (8, 9).

2. Thyristor suivant la revendication 1, caractérisé en ce qu'il est prévu au moins une autre zone d'émetteur du type N ou une autre zone d'émetteur du type P (1b) qui est munie d'au moins une autre partie de la cathode ou de l'anode (9), que l'autre zone d'émetteur du type N ou zone d'émetteur du type P (1b) est traversée par au moins une autre zone (20) de la couche de base s'étend jusqu'à la surface limite (1a) du corps semiconducteur et est reliée, dans cette dernière, à une autre partie de la cathode ou de l'anode (19).

3. Thyristor suivant l'une des revendications précédentes, caractérisé par le fait qu'une couche de base (2) ou une autre zone de cette couche de base est pourvue d'une électrode d'amorçage (23) qui possède une borne (Z) pour un circuit d'amorçage (Z1).

4. Thyristor suivant la revendication 3, caractérisé en ce que la borne (Z) pour le circuit d'amorçage (Z1) est reliée à la borne (G) d'application de la tension de commande, des structures MIS.

5. Procédé pour la mise en œuvre d'un thyristor comportant un corps semiconducteur, qui comporte une couche extérieure d'émetteur du type N (1), munie d'une cathode (6), une couche extérieure d'émetteur du type P (4), munie d'une anode (5), et deux couches de base (2, 3) contiguës à ces couches d'émetteurs, et comportant des courts-circuits d'émetteur (8, 1, 11, 13, 14; 9, 1, 12, 16, 17) pouvant être commandés, réalisés sous la forme de structures MIS et disposés au niveau d'une surface limite du corps semiconducteur et constitués respectivement par une première région semiconductrice (8, 9) d'un premier type de conductivité, reliée à l'anode ou à la cathode, une seconde région semiconductrice (11, 12) du premier type de conductivité, reliée à la couche de base tournée vers la cathode ou vers l'anode, et une couche intercalaire possédant un second type de conductivité, qui est disposée entre lesdites couches semiconductrices et qui est recouverte par une grille isolée électriquement par rapport au corps semiconducteur, et comportant une couche d'émetteur du type N ou une couche d'émetteur du type P, qui est subdivisée en plusieurs zones d'émetteur (1), qui sont munies respectivement de parties (6, 7), reliées de façon conductrice entre elles, de la cathode ou de l'anode, et plusieurs structures MIS en forme de bandes (8, 1, 11, 13, 14; 9, 1, 12, 16, 17) qui sont disposées respectivement sur le bord des zones d'émetteur (1), et des grilles (14, 17, 18) des structures MIS, qui possèdent une borne commune (G) d'application d'une tension de commande, caractérisé par le fait qu'à la borne (G) d'application d'une tension de commande est envoyée, pour l'amorçage du thyristor, une impulsion de tension (P1) rendant inactifs les courts-circuits.

6. Procédé suivant la revendication 5, caractérisé par le fait qu'à la borne (G) d'application d'une tension de commande, des structures MIS du type à appauvrissement associées aux zones d'émetteur du type N ou P, est envoyée une impulsion de tension (P1) positive ou négative déclenchant la commutation du thyristor de l'état bloqué à l'état conducteur.

11     **0 030 274**     12

7. Procédé suivant la revendication 5, caractérisé par le fait qu'une impulsion de tension d'amorçage, pouvant être prélevée sur la borne (Z) pour le circuit d'amorçage (Z1), est envoyée sous la forme d'une impulsion de tension positive ou négative, déclenchant la commutation du thyristor de l'état bloqué à l'état conducteur, à la borne (G) d'application d'une tension de commande, des structures MIS du type à appauvrissement associées aux zones d'émetteur du type N ou P.

7

# FIG 1

# FIG 2

# FIG 3

0 030 274